# EUROPÄISCHE PATENTANMELDUNG

(11) **EP 4 123 819 A2**
(43) Veröffentlichungstag der Anmeldung: **25.01.2023**
(21) Anmeldenummer: 22179228.6
(22) Anmeldetag: 15.06.2022
(51) Int. Cl.: H01M 50/503, H01M 50/507, H01M 50/528, B23K 11/00, B23K 26/22, B23K 35/00

(54) **AKKUPACK**

(30) Priorität: 30.06.2021 DE 102021206819
(71) Anmelder: Robert Bosch GmbH, 70442 Stuttgart (DE)
(72) Erfinder: Schramm, Simone, 72070 Tuebingen (DE); Zahn, Wolf, 70439 Stuttgart (DE); Ruthardt, Aaron, 71157 Hildrizhausen (DE); Becsei, Balint, 1039 Budapest (HU); Gollhofer, Stephanie, 72764 Reutlingen (DE); Buck, Simon, 72813 St. Johann (DE)

(57) **Zusammenfassung**

Die Erfindung betrifft einen Akkupack mit einem Gehäuse, mit zumindest einer Akkuzelle, mit einem Zellverbinder und mit einer Leiterplatte, wobei die zumindest eine Akkuzelle über den Zellverbinder mit der Leiterplatte elektrisch verbunden ist. Es wird vorgeschlagen, dass die Leiterplatte eine Verbindungsstelle zur stoffschlüssigen Verbindung des Zellverbinders mit der Leiterplatte aufweist, wobei die Verbindungsstelle auf einer den Akkuzellen abgewandten Seite der Leiterplatte angeordnet ist.

## Beschreibung

### Stand der Technik

In der DE 10 2019 213 965 A1 ist ein Akkupack mit einem Zellenhalter beschrieben.

### Offenbarung der Erfindung

Die Erfindung betrifft insbesondere einen Akkupack mit einem Gehäuse, mit einer Mehrzahl von Akkuzellen, die in dem Gehäuse angeordnet sind, mit zumindest zwei Einzelzellenaufnahmen, die in einer ersten Hauptebene angeordnet sind, mit zumindest zwei Einzelzellenaufnahmen die in einer zweiten Hauptebene angeordnet sind, mit zumindest einer Einzelzellenaufnahme, die in einer Zwischenebene angeordnet ist, wobei die Hauptebenen und die Zwischenebene parallel zueinander und durch eine Mittelachse der jeweiligen Einzelzellenaufnahmen verlaufen. Es wird vorgeschlagen, dass die Einzelzellenaufnahmen derart angeordnet sind, dass ein Abstand zwischen der Hauptebene und der Zwischenebene in einem Bereich zwischen 54% und 60%, insbesondere in einem Bereich zwischen 56% und 58%, eines Durchmessers der Akkuzellen liegt. Vorteilhaft kann dadurch ein Akkupack mit einer optimalen Geometrie für einen flexiblen Einbau in einen Verbraucher bereitgestellt werden.

Der Akkupack ist insbesondere Teil eines Systems, das sich aus dem Akkupack und einem Verbraucher zusammensetzt, wobei der Verbraucher während des Betriebs über den Akkupack mit Energie versorgt wird. Der Akkupack kann beispielsweise als ein Handwerkzeugmaschinenakkupack oder als ein Elektrofahrradakkupack ausgebildet sein. Der Akkupack ist insbesondere als ein Wechselakkupack ausgebildet, der bevorzugt werkzeuglos lösbar mit dem Verbraucher ausgebildet ist. Der Akkupack ist insbesondere verbindbar mit einer Ladevorrichtung zum Aufladen des Akkupacks ausgebildet. Alternativ oder zusätzlich kann der Akkupack auch derart ausgebildet sein, dass er im mit dem Verbraucher verbundenen Zustand aufladbar ist.

Der Verbraucher kann insbesondere als ein Gartengerät, wie beispielsweise ein Rasenmäher oder eine Heckenschere, als ein Haushaltsgerät, wie beispielsweise ein elektrischer Fensterreiniger oder Handstaubsauger, als eine Handwerkzeugmaschine, wie beispielsweise ein Winkelschleifer, ein Schrauber, eine Bohrmaschine, ein Bohrhammer, etc., als ein elektrisches Fortbewegungsmittel, wie beispielsweise ein Elektrofahrrad in Form eines Pedelecs oder eBikes, oder als ein Messwerkzeug, wie beispielsweise ein Laserentfernungsmessgerät, ausgebildet sein. Des Weiteren ist auch denkbar, dass der Verbraucher als ein anderes insbesondere tragbares Gerät ausgebildet ist, wie beispielsweise eine Baustellenbeleuchtung, ein Absauggerät oder ein Baustellenradio.

Das Gehäuse des Akkupacks ist vorzugsweise als ein Außengehäuse ausgebildet. Der Akkupack, insbesondere das Gehäuse des Akkupacks, kann über eine mechanische Schnittstelle lösbar mit dem Verbraucher und/oder einer Ladevorrichtung verbindbar sein. Das Gehäuse des Akkupacks kann ein oder mehrere Gehäuseteile aufweisen. Das Gehäuse weist zumindest ein Gehäuseteil auf, das als ein Außengehäuseteil ausgebildet ist. Das Außengehäuseteil grenzt dabei den Akkupack nach außen ab und kann von einem Benutzer berührt werden. Zudem kann das Gehäuse zumindest ein Innengehäuseteil aufweisen, dass vollständig von dem zumindest einen Gehäuseteil umschlossen wird. Insbesondere weist das Gehäuse des Akkupacks einen Zellenhalter zur Aufnahme der Akkuzellen auf, wobei die Einzelzellenaufnahmen dem Zellenhalter zugeordnet sind. Vorzugsweise ist der Zellenhalter als eines der Gehäuseteile ausgebildet, wobei der Zellenhalter als ein Außengehäuseteil und/oder als ein Innengehäuseteil ausgebildet sein kann. Das Gehäuse des Akkupacks kann einen oder mehrere Zellenhalter aufweisen. Die Gehäuseteile sind miteinander kraft-, form- und/oder stoffschlüssig verbunden.

Der Zellenhalter ist vorzugsweise aus einem Kunststoff, insbesondere einem thermoplastischen Kunststoff, ausgebildet. Der Zellenhalter ist bevorzugt aus einem temperaturbeständigen Kunststoff, bevorzugt aus einem faserverstärkten Kunststoff, ausgebildet. Der Zellenhalter ist insbesondere einteilig oder einstückig ausgebildet. Unter einstückig soll im Zusammenhang dieser Anmeldung insbesondere ein Bauteil verstanden werden, dass aus einem Stück ausgebildet und nicht aus mehreren Bauteilen, die stoffschlüssig und/oder kraft- und/oder formschlüssig miteinander verbunden sind, ausgebildet ist. Ein einstückiges Bauteil besteht demnach aus einem einzigen Material. Unter einteilig soll im Zusammenhang dieser Anmeldung mehrere Bauteile, die stoffschlüssig, beispielsweise über ein 2K Spritzguss oder einen Stoffschluss, miteinander verbunden sind, verstanden werden. Eine einteilige Komponente kann somit aus einem oder mehreren Materialien bestehen. Alternativ ist auch denkbar, dass der Zellenhalter mehrteilig ausgebildet ist, wobei die unterschiedlichen Teile kraft- und/oder formschlüssig miteinander verbunden sind. Der Akkupack kann einen oder mehrere Zellenhalter, die nebeneinander und/oder hintereinander angeordnet sind, aufweisen.

Über eine mechanische Schnittstelle ist der Akkupack kraft- und/oder formschlüssig mit dem Verbraucher verbindbar. Vorteilhaft umfasst die mechanische Schnittstelle zumindest ein Betätigungselement, über das die Verbindung des Ackupacks mit dem Verbraucher und/oder mit der Ladevorrichtung lösbar ist. Das Betätigungselement kann beispielsweise als ein Schloss, ein Knopf, ein Hebel oder als ein Taster ausgebildet sein. Das Betätigungselement kann am Akkupack oder am Verbraucher angeordnet sein.

Zudem weist der Akkupack zumindest eine elektrische Schnittstelle auf, über die der Akkupack mit dem Verbraucher und/oder mit der Ladevorrichtung elektrisch verbindbar ist. Über die elektrische Verbindung kann der Akkupack beispielsweise geladen und/oder entladen werden. Alternativ oder zusätzlich ist auch denkbar, dass über die elektrische Schnittstelle Informationen von dem Akkupack an den Verbraucher und umgekehrt übermittelbar sind. Die elektrische Schnittstelle ist bevorzugt als eine Kontaktschnittstelle ausgebildet, bei der die elektrische Verbindung über einen physischen Kontakt zumindest zweier leitfähiger Bauteile erfolgt. Die elektrische Schnittstelle umfasst bevorzugt zumindest zwei elektrische Kontaktelemente. Insbesondere ist einer der elektrischen Kontaktelemente als ein Plus-Kontakt und das andere elektrische Kontaktelement als ein Minus-Kontakt ausgebildet. Zusätzlich kann die elektrische Schnittstelle zumindest einen Zusatzkontakt aufweisen, der dazu ausgebildet ist, zusätzliche Informationen an den Verbraucher und/oder an die Ladevorrichtung zu übertragen.

Die Zusatzkontakte können als Signalkontakte, Codierkontakte, Temperaturkontakte, Bus-Kontakte etc. ausgebildet sein. Die elektrischen Kontaktelemente können beispielsweise als federnde Kontaktelemente in Form von Kontakttulpen oder als Flachkontakte in Form von Kontaktklingen ausgebildet sein. Alternativ oder zusätzlich kann die elektrische Schnittstelle ein sekundäres Ladespulenelement zur induktiven Ladung aufweisen.

Des Weiteren umfasst der Akkupack vorzugsweise eine Elektronik. Die Elektronik kann beispielsweise eine Leiterplatte, eine Recheneinheit, eine Steuereinheit, einen Transistor, einen Kondensator, und/oder eine Speichereinheit aufweisen. Zusätzlich oder alternativ ist ebenfalls denkbar, dass Informationen von der Elektronik ermittelt werden. Die Elektronik ist zur Steuerung oder Regelung des Akkupacks und/oder des Verbrauchers ausgebildet. Die Elektronik umfasst insbesondere ein BMS (engl. Battery Management System), das zur Überwachung des Akkupacks ausgebildet ist. Das BMS ist insbesondere dazu ausgebildet, eine Überladung und/oder eine Tiefenentladung des Akkupacks zu verhindern. Vorzugsweise ist das BMS zur korrekten Zellsymmetrierung ausgebildet. Die Elektronik kann zudem ein oder mehrere Sensorelemente aufweisen, beispielsweise einen Temperatursensor zur Ermittlung der Temperatur innerhalb des Akkupacks oder einen Bewegungssensor zur Ermittlung von Bewegungen. Die Elektronik kann alternativ oder zusätzlich ein Kodierungselement, wie beispielsweise ein Kodierungswiderstand, aufweisen. Die elektrischen Kontaktelemente der elektrischen Schnittstelle des Akkupacks können auf der Leiterplatte der Elektronik angeordnet oder mit der Leiterplatte verbunden sein. Unter einer Leiterplatte soll im Zusammenhang dieser Anmeldung ein Schaltungsträger verstanden werden, der ein organisches oder anorganisches Substrat, beispielsweise IMS, aufweist. Die Leiterplatte kann als eine starre Leiterplatte oder als eine flexible Leiterplatte ausgebildet sein. Zudem kann es sich bei der Leiterplatte um eine bestückte oder eine unbestückte Leiterplatte handeln. Die Leiterplatte kann eine einzelne Lage aufweisen oder mehrlagig ausgebildet sein.

Der Zellenhalter weist zumindest eine Akkuzellenaufnahme auf. Die Akkuzellenaufnahme kann als eine Einzelzellenaufnahme zur Aufnahme einer einzelnen Ackuzelle oder als eine Mehrzellenaufnahme zur Aufnahme mehrerer Akkuzellen ausgebildet sein. Die Akkuzellenaufnahme ist insbesondere derart ausgebildet, dass im mit der Akkuzelle verbundenen Zustand ein Großteil der Außenfläche, insbesondere ein Großteil der Mantelfläche der Akkuzelle, von der Akkuzellenaufnahme umschlossen ist. Insbesondere ist zumindest 60%, vorzugsweise zumindest 75%, bevorzugt zumindest 90%, der Mantelfläche der Akkuzelle von der Akkuzellenaufnahme umschlossen. Vorzugsweise ist die Akkuzellenaufnahme derart ausgebildet, dass die zumindest eine Akkuzelle an einer Innenfläche der Akkuzellenaufnahme anliegt und durch die Akkuzellenaufnahme fixiert ist. Der Zellenhalter weist zwischen zwei Akkuzellenaufnahmen eine Wandung auf, die die Akkuzellenaufnahmen räumlich und elektrisch und/oder thermisch voneinander isoliert.

Die Akkuzelle kann als eine galvanische Zelle ausgebildet sein, die einen Aufbau aufweist, bei dem ein Zellpol an einem Ende und ein weiterer Zellpol an einem gegenüberliegenden Ende zu liegen kommen. Insbesondere weist die Akkuzelle an einem Ende einen positiven Zellpol und an einem gegenüberliegenden Ende einen negativen Zellpol auf. Bevorzugt sind die Akkuzellen als NiCd- oder NiMh-, besonders bevorzugt als lithiumbasierte Akkuzellen bzw. Li-Ion Akkuzellen, ausgebildet. Alternativ ist beispielhaft auch denkbar, dass die Akkuzelle als eine Pouchzelle ausgebildet ist. Die Akkuspannung des Akkupacks ist in der Regel ein Vielfaches der Spannung einer einzelnen Akkuzelle und ergibt sich aus der Schaltung (parallel oder seriell) der Akkuzellen. Bei gängigen Akkuzellen mit einer Spannung von 3,6 V ergeben sich somit beispielhafte Akkuspannung von 3,6 V, 7,2 V, 10, 8 V, 14,4 V, 18 V, 36 V, 54 V, 108 V etc. Bevorzugt ist die Akkuzelle als zumindest im Wesentlichen zylinderförmige Rundzelle ausgebildet, wobei die Zellpole an Enden der Zylinderform angeordnet sind.

Insbesondere weist der Akkupack zumindest einen Zellverbinder auf, der zur elektrischen Verbindung der Akkuzellen mit der Elektronik, insbesondere mit der Leiterplatte und/oder mit den elektrischen Kontaktelementen, ausgebildet ist. Die Zellverbinder können einstückig, einteilig oder mehrteilig ausgebildet sein. Die Zellverbinder können kraft- und/oder formschlüssig mit dem Gehäuse des Akkupacks, insbesondere dem Zellenhalter, verbunden sein. Es ist ebenso denkbar, dass der Zellverbinder teilweise oder vollständig von dem Gehäuse, insbesondere dem Zellenhalter, umspritzt ist. Der Zellverbinder ist aus einem metallischen Werkstoff ausgebildet. Der Zellverbinder kann beispielsweise aus einem Reinkupfer (Kupfergehalt >95%), einer Kupferlegierung oder einer Nickel-Verbindung, einem Stahl, insbesondere Hilumin, einer Aluminiumlegierung oder Aluminium ausgebildet sein. Die Zellverbinder können an Stirnseiten oder an der Mantelfläche der Akkuzellen mit diesen stoffschlüssig verbunden sein.

Der Zellverbinder weist ein Zellverbindungselement zur elektrischen Verbindung der Akkuzellen und ein Leiterplattenverbindungselement zur elektrischen Verbindung mit der Leiterplatte auf. Das Zellverbindungselement liegt dabei direkt und unmittelbar an der Akkuzelle, insbesondere einem Zellpol der Akkuzelle, an und ist bevorzugt stoffschlüssig mit dem Zellpol verbunden. Der Stoffschluss kann über ein Lötverfahren oder über ein Schweißverfahren, insbesondere über ein Widerstandsschweißverfahren oder über ein Laserschweißverfahren, erfolgen. Alternativ oder zusätzlich ist auch ein Stoffschluss über ein Ultraschallschweißverfahren denkbar. Die Schweißverbindung unterscheidet sich in diesem Kontext von der Lötverbindung insbesondere dadurch, dass bei der Schweißverbindung ein teilweises Aufschmelzen der zu verbindenden Bauteile erfolgt. Der Stoffschluss kann unter Zuhilfenahme eines Stoffschlussmittels erfolgen. Im Falle eines Lötverfahren ist das Stoffschlussmittel als Lot oder Lötschicht ausgebildet. Im Falle eines Schweißverfahrens kann das Stoffschlussmittel beispielsweise als ein Metallplättchen ausgebildet sein, dass lokal den Widerstand erhöht. Das Leiterplattenverbindungselement kann direkt mit der Leiterplatte, beispielsweise einer Kontaktfläche der Leiterplatte, oder indirekt, beispielsweise über ein elektrisches Kontaktelement, mit der Leiterplatte verbunden sein.

Die Leiterplatte ist vorzugsweise als eine starre Leiterplatte mit einem organischen Substrat ausgebildet. Die Leiterplatte weist eine Oberseite und eine Unterseite auf, wobei die Unterseite den Akkuzellen zugewandt ist. Die Leiterplatte kann eine oder mehrere Aussparungen für die Zellverbinder aufweisen. Die Aussparung ist derart ausgebildet, das mittels der Aussparung ein Durchgang zwischen der Oberseite und der Unterseite gebildet wird. Die Aussparung kann am Rand der Leiterplatte oder innerhalb der Leiterplatte angeordnet sein. Die Aussparung kann somit eine geschlossene oder eine offene Kante aufweisen.

Die Mittelachsen der Einzelzellenaufnahmen erstrecken sich koaxial oder parallel zu einer Aufnahmerichtung, entlang der die Akkuzellen in den Einzelzellenaufnahmen aufgenommen bzw. eingeschoben werden. Der Durchmesser der Ackuzellen unterliegt fertigungsbedingt einer gewissen Toleranz. Die Einzelzellenaufnahmen können starr ausgebildet sein, wobei ein Innendurchmesser der Einzelzellenaufnahmen größer als der Durchmesser der Akkuzellen ausgebildet ist. Akkuzellen mit einem toleranzbedingt größeren Durchmesser haben somit einen geringeren Spiel in der Einzelzellenaufnahme als Akkuzellen mit einem toleranzbedingt kleineren Durchmesser. Die Einzelzellenaufnahmen können zudem ein Befestigungsmittel zur radialen Fixierung der Akkuzellen in den Einzelzellenaufnahmen aufweisen. Vorteilhaft kann somit eine spielfreie und stabile Aufnahme realisiert werden. Die radiale Fixierung erfolgt über eine Beaufschlagung der Ackuzelle durch das Befestigungsmittel mit einer radial wirkenden Kraft.

Eine Mittelachse der zylindrischen Akkuzellen verläuft im aufgenommenen Zustand im Wesentlichen koaxial zu der Mittelachse der Einzelzellenaufnahmen. Aufgrund der Herstellungstoleranz kann die Mittelachse der Akkuzellen parallel und leicht versetzt zu der Mittelachse de Einzelzellenaufnahmen verlaufen.

Des Weiteren wird vorgeschlagen, dass der Zellenhalter 2n+3 Einzelzellenaufnahmen aufweist, wobei n ≥ 1, insbesondere 1 ist. Vorteilhaft kann dadurch eine ausreichend große Leistungsversorgung für den Verbraucher realisiert werden. Der Akkupack, insbesondere der Zellenhalter, weist je Hauptebene zumindest zwei Akkuzellen auf. Die Zwischenebene kann eine oder mehrere Akkuzellen aufweisen.

Weiterhin wird vorgeschlagen, dass ein Abstand zwischen den zwei Hauptebenen größer als ein Abstand zwischen den Mittelachsen der Einzelzellenaufnahmen in den jeweiligen Hauptebenen ausgebildet ist. Der Abstand der Akkuzellen innerhalb einer Hauptebene ist vorzugsweise gleich ausgebildet.

Zudem wird vorgeschlagen, dass die benachbarten Hauptebenen im Wesentlichen den gleichen Abstand von der Zwischenebene aufweisen. Vorteilhaft kann dadurch eine optimale Gewichtsverteilung im Akkupack realisiert werden.

Des Weiteren wird vorgeschlagen, dass der Zellenhalter einen Leiterplattenaufnahmebereich aufspannt, der zur Aufnahme der Leiterplatte ausgebildet, wobei die Leiterplatte teilweise oder vollständig in dem Leiterplattenaufnahmebereich angeordnet ist. Vorteilhaft kann dadurch die Leiterplatte geschützt durch den Zellenhalter angeordnet werden. Der Zellenhalter kann eine Ausnehmung für zumindest einen Temperatursensor auf. Der Temperatursensor kann direkt auf der Leiterplatte oder indirekt mit der Leiterplatte, beispielsweise über eine Kabelverbindung oder eine Flex-PCB, verbunden sein. Der Temperatursensor kann beispielsweise als eine PTC oder als ein NTC ausgebildet sein.

Weiterhin wird vorgeschlagen, dass die Leiterplatte derart angeordnet ist, dass eine durch die Leiterplatte aufgespannte Leiterplattenebene parallel zu der Hauptebene angeordnet ist. Insbesondere ist die Leiterplatte derart angeordnet, dass die Leiterplattenebene einen Abstand von der Zwischenebene aufweist, der in einem Bereich zwischen 30% und 55%, vorzugsweise in einem Bereich zwischen 40% und 45%, des Durchmessers der Akkuzellen liegt.

Zudem betrifft die Erfindung einen Zellenhalter für einen Akkupack wie zuvor beschrieben.

Die Erfindung betrifft einen Akkupack mit einem Gehäuse, mit zumindest einer Akkuzelle, mit einem Zellverbinder und mit einer Leiterplatte, wobei die zumindest eine Akkuzelle über den Zellverbinder mit der Leiterplatte elektrisch verbunden ist. Es wird vorgeschlagen, dass die Leiterplatte eine Verbindungsstelle zur stoffschlüssigen Verbindung des Zellverbinders mit der Leiterplatte aufweist, wobei die Verbindungsstelle auf einer den Akkuzellen abgewandten Seite der Leiterplatte angeordnet ist. Vorteilhaft kann dadurch eine sichere Anbindung des Zellverbinders an die Leiterplatte realisiert werden.

Die Verbindungsstelle kann für ein Schweißverfahren und/oder für ein Lötverfahren vorgesehen sein. Die Verbindungsstelle weist eine Kontaktfläche auf. Die Kontaktfläche ist vorzugsweise auf einer Außenlage der Leiterplatte angeordnet. Die Kontaktfläche ist insbesondere als eine Oberflächenmetallisierung, beispielsweise als ein Kupferpad, ausgebildet. Die Verbindungsstelle ist vorzugsweise mit einer Leiterbahn der Leiterplatte verbunden. Die Verbindungsstelle kann ein Stoffschlussmittel, wie beispielsweise ein Lötpad oder ein Schweißplättchen, aufweisen.

Des Weiteren wird vorgeschlagen, dass der Akkupack eine Montagehilfe zur Unterstützung der Montage aufweist. Die Montagehilfe kann einstückig oder einteilig mit dem Gehäuse, insbesondere dem Zellenhalter, ausgebildet sein. Die Unterstützung der Verbindung des Zellverbinders mit der Leiterplatte erfolgt während des Montageprozesses oder im verbundenen Zustand.

Weiterhin wird vorgeschlagen, dass die Leiterplatte eine Aussparung aufweist, in der die Montagehilfe und der Zellverbinder angeordnet sind, wobei die Montagehilfe eine Länge aufweist, die größer als eine Dicke der Leiterplatte ausgebildet ist. Insbesondere weist die Montagehilfe auf der der Verbindungsstelle abgewandten Seite eine abgerundete Kante auf, die zum Biegen des Zellverbinders vorgesehen ist. Vorteilhaft wird dadurch die Wahrscheinlichkeit einer Beschädigung des Zellverbinders bei der Montage verringert.

Zudem wird vorgeschlagen, dass der Akkupack ein Stützelement aufweist, auf welchem die Leiterplatte im Bereich der Verbindungsstelle aufliegt. Das Stützelement ist vorzugsweise auf einer den Akkuzellen zugewandten Seite der Leiterplatte angeordnet. Das Stützelement ist zur Abstützung der Leiterplatte während des Schweißverfahrens oder Lötverfahrens ausgebildet, sodass die mechanische Belastung der Leiterplatte verringert wird. Das Stützelement kann einstückig oder einteilig mit dem Gehäuse, insbesondere mit dem Zellenhalter, des Akkupacks ausgebildet sein. Zwischen dem Stützelement und der Leiterplatte kann auch ein Luftspalt ausgebildet sein, der sich durch eine mechanische Belastung der Leiterplatte im Schweiß- oder Lötprozess schließt. Das Stützelement kann starr oder flexibel ausgebildet sein. Unter einem starren Stützelement soll verstanden werden, dass das Stützelement unter der Belastung beim Verbindungsprozess nicht nachgibt und seine Form nicht verändert. Unter einem flexiblen Stützelement soll verstanden werden, dass das Stützelement während des Verbindungsprozess elastisch oder plastisch nachgibt.

Des Weiteren wird vorgeschlagen, dass die Leiterplatte eine Kontaktfläche aufweist, die stoffschlüssig über ein Stoffschlussmittel mit einem Schweißplättchen verbunden ist. Das Stoffschlussmittel kann beispielsweise als eine Lötschicht oder als eine Klebeschicht bzw. einen Klebefilm ausgebildet sein. Die Kontaktfläche ist der Verbindungsstelle zugeordnet. Die Lötschicht ist zur stoffschlüssigen Verbindung des Schweißplättchens mit der Kontaktfläche vorgesehen. Das Schweißplättchen besteht aus einem metallischen Werkstoff. Der metallische Werkstoff ist an den Werkstoff des Zellverbinders angepasst. Das Schweißplättchen ist zur stoffschlüssigen Verbindung des Zellverbinders mit der Verbindungsstelle über ein Schweißverfahren ausgebildet.

Weiterhin wird vorgeschlagen, dass der Zellverbinder, insbesondere ein Dimpel des Zellverbinders, direkt mit dem Schweißplättchen verbunden ist. Vorteilhaft kann dadurch eine optimale Schweißverbindung hergestellt werden. Der Dimpel ist derart ausgebildet, dass das Schweißplättchen nur teilweise mit dem Zellverbinder in Kontakt tritt.

Zudem wird vorgeschlagen, dass die Lötschicht und/oder die Kontaktfläche und/oder das Schweißmetallplättchen eine Aussparung aufweist. Die Aussparung ist insbesondere derart ausgebildet, dass zwischen dem Schweißmetallplättchen und der Leiterplatte ein Hohlraum gebildet wird. Vorteilhaft wird dadurch der Wärmetransport im Bereich der Aussparung verringert, wodurch durch die Leiterplatte während es Schweißprozesses vor einer Beschädigung geschützt wird. Die Aussparungen können benachbart zueinander und/oder versetzt zueinander angeordnet sein. Die Lötschicht und/oder die Kontaktfläche und/oder das Schweißmetallplättchen können eine oder mehrere Aussparungen aufweisen, insbesondere unterschiedliche Anzahl von Aussparungen aufweisen.

Des Weiteren wird vorgeschlagen, dass das Schweißmetallplättchen einen Dimpel aufweist, der sich in eine der Leiterplatte abgewandten Richtung erstreckt. Der Dimpel ist derart ausgebildet, dass sich zwischen dem Schweißmetallplättchen und der Leiterplatte ein Hohlraum bildet.

Zudem wird vorgeschlagen, dass die Aussparung in einem Schweißbereich, insbesondere im Bereich des Dimpels, angeordnet ist. Vorteilhaft wird dadurch der Wärmetransport in einem Bereich mit hohen Temperaturen während des Schweißprozesses verringert.

Des Weiteren wird vorgeschlagen, dass die Lötschicht und/oder die Kontaktfläche zumindest einen Entgasungskanal zur Expansion eingeschlossener Luft aufweist. Vorteilhaft kann dadurch ein sicherer Schweißvorgang realisiert werden.

Die Erfindung betrifft ferner ein Verfahren zum Verschweißen eines Zellverbinders auf einer Leiterplatte, wobei der Zellverbinder über ein Schweißplättchen auf eine Kontaktfläche der Leiterplatte aufgeschweißt wird. Es wird vorgeschlagen, dass im direkten Schweißbereich ein Hohlraum zwischen dem Schweißplättchen und der Leiterplatte angeordnet ist. Vorteilhaft wird dadurch die Wärme optimal zur stoffschlüssigen Verbindung eingebracht. Der direkte Schweißbereich ist dabei der Bereich, welcher in unmittelbarer Umgebung der Wärmeeinbringung angeordnet ist. Im Falle eines Widerstandschweißverfahrens ist der direkte Schweißbereich im Bereich der Auflagefläche der Schweißelektroden und/oder im Bereich der Auflagefläche der Dimpel angeordnet. Im Falle eines Laserschweißverfahrens entspricht der Schweißbereich dem Bereich, der dem Laserstrahl ausgesetzt ist.

Des Weiteren wird vorgeschlagen, dass das Schweißplättchen über eine Lötschicht mit der Leiterplatte verbunden ist und die Lötschicht und/oder die Kontaktfläche und/oder das Schweißmetallplättchen eine Aussparung aufweist. Das Schweißen erfolgt vorzugsweise über ein Widerstandsschweißverfahren oder ein Laserschweißverfahren.

Weiterhin wird vorgeschlagen, dass die Aussparung der Lötschicht mittels eines Lötstopplacks hergestellt wird.

### Zeichnungen

Weitere Vorteile ergeben sich aus der folgenden Zeichnungsbeschreibung. Die Zeichnungen, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen. Bezugszeichen von Merkmalen unterschiedlicher Ausführungsformen der Erfindung, die sich im Wesentlichen entsprechen, werden mit derselben Zahl und mit einem die Ausführungsform kennzeichnenden Buchstaben versehen.

Es zeigen:
- Fig. 1: eine perspektivische Ansicht eines Elektrofahrrads mit einem erfin-dungsgemäßen Akkupack;
- Fig. 2: eine perspektivische Ansicht des Akkupacks ohne Gehäuse;
- Fig. 3: eine Vorderansicht eines Zellenhalters mit eingesetzten Akkuzellen des Akkupacks;
- Fig. 4: einen Schnitt durch eine Verbindungsstelle des Akkupacks;
- Fig. 5a: eine schematische Seitenansicht der Verbindungsstelle gemäß Fig. 4;
- Fig. 5b: eine schematische Draufsicht der Verbindungsstelle gemäß Fig. 4;
- Fig. 6a: eine schematische Seitenansicht einer alternative Ausführungsform einer Verbindungsstelle für einen Akkupack;
- Fig. 6b: eine schematische Draufsicht der Verbindungsstelle gemäß Fig. 6a.

### Beschreibung der Ausführungsbeispiele

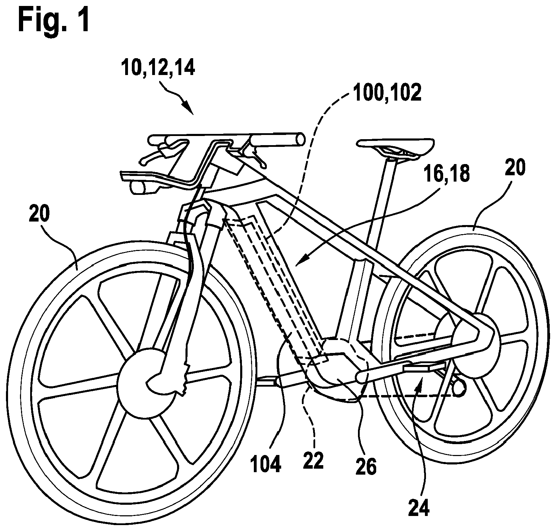

In Fig. 1 ist ein Verbraucher 10 mit einem erfindungsgemäßen Akkupack 100 in einer schematischen Seitenansicht gezeigt. Der Verbraucher 10 ist beispielhaft als ein elektrisch angetriebenes Fortbewegungsmittel 12, insbesondere als ein Elektrofahrrad 14, ausgebildet. Das Elektrofahrrad 14 kann beispielsweise als ein Pedelec oder als ein E-Bike ausgebildet sein.

Das Elektrofahrrad 14 weist ein Gehäuse 16 in Form eines Rahmens 18 bzw. eines Fahrradrahmens auf. Mit dem Rahmen 18 sind zwei Räder 20 verbunden. Zudem weist der Verbraucher 10 eine Antriebseinheit 22 auf, die einen Elektromotor bzw. Hilfsmotor umfasst. Der Elektromotor ist vorzugsweise als ein Permanentmagnet-erregter, bürstenloser Gleichstrommotor ausgebildet. Der Elektromotor ist beispielhaft als ein Mittelmotor ausgebildet, wobei auch ein Nabenmotor oder dergleichen denkbar ist.

Die Antriebseinheit 22 umfasst eine Steuereinheit (nicht dargestellt), die zur Steuerung oder Regelung des Elektrofahrrads 14, insbesondere des Elektromotors, ausgebildet ist. Das Elektrofahrrad 14 weist eine Tretkurbel 24 auf. Die Tretkurbel 24 weist eine Tretkurbelwelle (nicht dargestellt) auf.

Die Steuereinheit und die Antriebseinheit 22 mit dem Elektromotor und der Tretkurbelwelle sind in einem mit dem Rahmen verbundenen Antriebsgehäuse 26 angeordnet. Die Antriebsbewegung des Elektromotors wird vorzugsweise über ein Getriebe (nicht dargestellt) auf die Tretkurbelwelle übertragen, wobei die Größe der Unterstützung durch die Antriebseinheit 22 mittels der Steuereinheit gesteuert oder geregelt wird.

Der Verbraucher 10 ist mit dem Akkupack 100 elektrisch und mechanisch verbunden, der zur Energieversorgung der Antriebseinheit 22 ausgebildet ist. Der Akkupack 100 ist als ein Wechselakkupack 102 ausgebildet. Der Rahmen 18 weist auf seiner Unterseite eine Öffnung auf, durch die der Akkupack 100 in den Rahmen 18 hineingeschoben oder geschwenkt werden kann. Die Öffnung wird im verbundenen Zustand durch ein Gehäuse 104 des Akkupacks 100 geschlossen. Alternativ ist auch denkbar, dass der Rahmen 18 selbst die Öffnung schließt oder durch eine Abdeckung geschlossen wird. Alternativ ist auch denkbar, dass der Akkupack 100 lösbar am Rahmen 18 oder an einem nicht dargestellten Gepäckträger befestigbar ausgebildet ist. Alternativ kann der Akkupack 100 auch von oben oder seitlich eingelegt werden. Zusätzlich ist es auch denkbar, dass der Akkupack 100 in ein geschlossenes Rahmenrohr von unten eingeschoben wird.

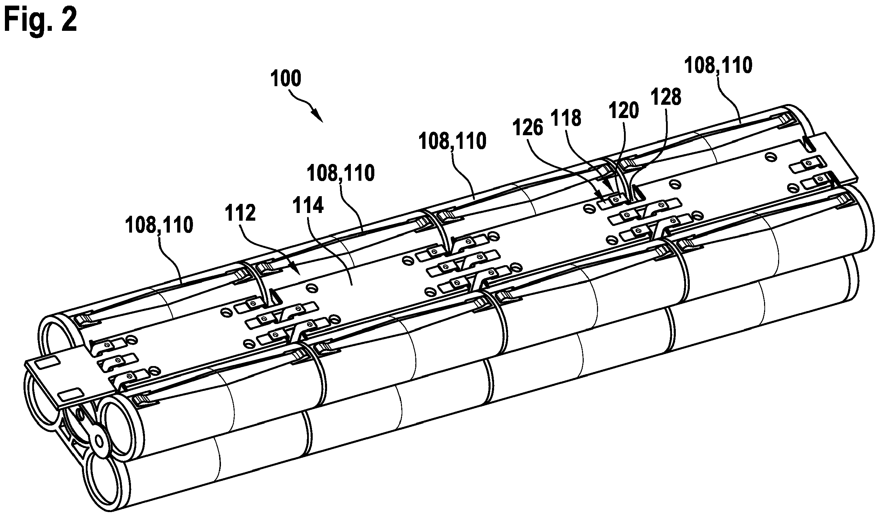

Der Akkupack 100 ist in Fig. 2 in einer perspektivischen Ansicht ohne das Gehäuse 104 des Akkupacks 100 gezeigt. Das Gehäuse 104 schließt den Akkupack 100 nach außen ab und ist aus einem Kunststoff ausgebildet. Zur lösbaren Verbindung weist der Akkupack 100 eine nicht dargestellte mechanische Schnittstelle auf, über die der Akkupack 100 am Elektrofahrrad 14 verriegelbar ist.

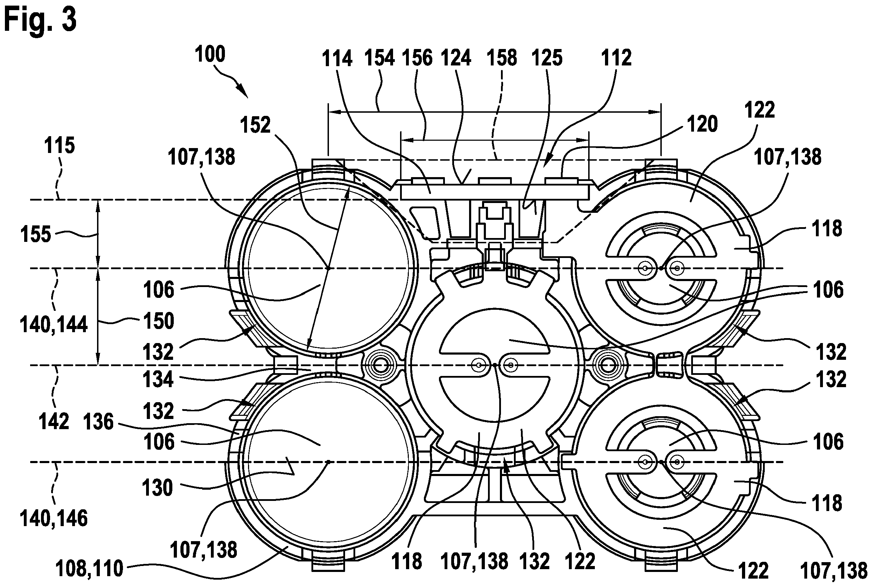

Der Akkupack 100 weist beispielhaft 20 Akkuzellen 106 (siehe Fig. 3) auf, die im inneren des Gehäuses 104 angeordnet sind. Das Gehäuse 104 weist zudem innenliegende Gehäuseteile 108 in Form von Zellenhaltern 110 auf. Die Zellenhalter 110 sind dazu ausgebildet, die Akkuzellen 106 aufzunehmen. Der Akkupack 100 weist beispielhaft vier Zellenhalter 110 auf, in denen jeweils fünf Akkuzellen 106 angeordnet sind. Die Zellenhalter 110 sind beispielhaft mehrteilig ausgebildet, wobei die Teile miteinander kraft- und formschlüssig verbunden sind. Es ist allerdings ebenso denkbar, dass die Zellenhalter 110 einteilig oder einstückig ausgebildet sind. Die Zellenhalter 110 sind derart hintereinander angeordnet, dass die in unterschiedlichen Zellenhaltern 110 aufgenommenen Akkuzellen 106 im Wesentlichen koaxial zueinander angeordnet sind.

Die Akkuzellen 106 sind als zylindrische Rundzellen ausgebildet. Die Akkuzellen 106 sind im Wesentlichen vollständig in den Zellenhaltern 110 angeordnet. Die Zellenhalter 110 umschließen die Akkuzellen 106 entlang ihrer Mantelflächen dabei im Wesentlichen vollständig. Die Akkuzellen 106 weisen eine Mittelachse 107 (siehe Fig. 3) auf, die einer mittigen Längsachse der Akkuzellen 106 entspricht. Innerhalb eines Zellenhalters 110 sind die Akkuzellen 106 nebeneinander angeordnet, sodass die Mittelachsen 107 der Akkuzellen 106 parallel zueinander angeordnet sind.

Der Akkupack 100 weist eine Elektronik 112 auf, die zur Steuerung oder Regelung des Akkupacks 100 und/oder des Verbrauchers 10 und/oder einer nicht gezeigten Ladevorrichtung ausgebildet ist. Die Elektronik 112 umfasst beispielhaft ein BMS zur Überwachung des Akkupacks 100.

Die Elektronik 112 umfasst eine Leiterplatte 114, die beispielhaft als eine ebene und starre Leiterplatte 114 ausgebildet ist. Die Leiterplatte 114 ist auf dem Zellenhalter 110 angeordnet und sitzt auf dem Zellenhalter 110. Die Leiterplatte 114 weist eine Länge auf, die im Wesentlichen einer Länge der Zellenhalter 110 entspricht.

Der Zellenhalter 110 und die Leiterplatte 114 weisen nicht dargestellte Verbindungselemente zur kraft- und/oder formschlüssigen Verbindung auf. Die Leiterplatte 114 spannt eine Leiterplattenebene 115 auf. Die Leiterplatte 114 bzw. die Leiterplattenebene 115 (siehe Fig. 3) erstreckt sich parallel zu den Akkuzellen 106 bzw. den Mittelachsen 107 der Akkuzellen 106.

Der Akkupack 100 weist zudem Zellverbinder 118 auf, die zur elektrischen Verbindung der Akkuzellen 106 mit der Elektronik 112 ausgebildet sind. Die Zellverbinder 118 sind zur Leistungsversorgung und/oder zur Überwachung der Einzelzellenspannung ausgebildet. Der Zellverbinder 118 besteht aus einem metallischen Werkstoff, beispielhaft aus einem Stahl wie Hilumin. In der gezeigten Ausführungsform sind alle Zellverbinder 118 direkt mit der Leiterplatte 114 verbunden. Alternativ wäre auch denkbar, dass einzelne Zellverbinder 118, beispielsweise die Zellverbinder zur Leistungsversorgung, direkt mit elektrischen Kontaktelementen (nicht dargestellt) des Akkupacks 100 verbunden sind.

Die Zellverbinder 118 sind beispielhaft einstückig ausgebildet. Die Zellverbinder 118 weisen ein Leiterplattenverbindungselement 120 zur Verbindung mit der Leiterplatte 114 und ein Zellenverbindungselement 122 (siehe Fig. 3) zur Verbindung mit den Akkuzellen 106 auf.

Die Leiterplatte 114 weist eine Oberseite 124, die den Akkuzellen 106 abgewandt ist, und eine Unterseite 125, die den Akkuzellen 106 zugewandt ist, auf. Auf der Oberseite 124 der Leiterplatte 114 sind Verbindungsstellen 126 angeordnet, über die der Zellverbinder 118, insbesondere das Leiterplattenverbindungselement 120, mit der Leiterplatte 114 beispielhaft über eine Schweißverbindung stoffschlüssig verbunden ist. Die Leiterplatte 114 weist Aussparung 128 auf, durch die die Zellverbinder 118 zu der Oberseite 124 der Leiterplatte 114 führbar sind.

In Fig. 3 ist eine Draufsicht auf einen der Zellenhalter 110 mit eingesetzten Ackuzellen 106 gezeigt. Es sind beispielhaft zwei Zellverbinder 118 gezeigt, die zur Einzelzellenüberwachung ausgebildet und mit der Leiterplatte 114 verbunden sind. Zudem sind die Zellverbinder 118 dazu ausgebildet, die Akkuzellen 106 miteinander seriell und/oder parallel zu verschalten. Die Zellverbinder 118 sind über das Zellenverbindungselement 122 mittels einer Widerstandsschweißverbindung mit den Akkuzellen 106, insbesondere mit den jeweiligen Zellpolen 130 der Ackuzellen 106, verbunden. Die Zellenverbindungselemente 122 erstrecken sich somit im Wesentlichen parallel zu den Zellpolen 130 der Akkuzellen 106. Die Zellpole 130 der Akkuzellen 106 sind im Wesentlichen senkrecht zu der Leiterplattenebene 115 angeordnet.

Der Zellenhalter 110 weist je Akkuzelle 106 eine Einzelzellenaufnahme 132 auf. Die Einzelzellenaufnahmen 132 umfassen eine zylindrische Wandung 134, die die Akkuzellen 106 entlang ihrer Mantelfläche umschließt. Die Wandungen 134 ist derart ausgebildet, dass sie zwischen zwei benachbarten Akkuzellen 106 zwei unterschiedlichen Einzelzellenaufnahmen 132 zugeordnet ist. Die Wandung 134 ist starr und beispielsweise aus einer Hartplastik ausgebildet. Zur spielfreien Befestigung der Akkuzelle 106 weist die Einzelzellenaufnahme 132 Befestigungsmittel 136 zur radialen Fixierung der Akkuzellen 106 in den Einzelzellenaufnahmen 132 auf. Die Befestigungsmittel 136 sind beispielhaft als federnde Rastarme ausgebildet, die im verbundenen Zustand die Mantelfläche der Akkuzelle 106 mit einer Kraft beaufschlagen. Die Befestigungsmittel 136 und die zylindrische Wandung 134 sind beispielhaft einstückig mit dem Zellenhalter 110 ausgebildet.

Die Einzelzellenaufnahmen 132 weisen jeweils eine Mittelachse 138 auf, die im Wesentlichen der Mittelachse 107 der Akkuzellen 106 entspricht. Abhängig von der Größe der Zelle kann dabei die Mittelachse 107 der Akkuzellen 106 einen geringen Versatz zu der Mittelachse der Einzelzellenaufnahmen 132 aufweisen.

Durch die Anordnung der Einzelzellenaufnahmen 132 zueinander wird die Geometrie des Akkupacks 100 maßgeblich bestimmt. Durch die im folgenden beschriebene Ausbildung des Zellenhalters 110 kann ein kompakter und flexibel in den Verbraucher 10 einbaubarere Akkupack 100 bereitgestellt werden.

Die Akkuzellen 106 sind auf zwei Hauptebenen 140 und einer Zwischenebene 142 verteilt, die parallel zueinander angeordnet. Der Zellenhalter 110 weist zwei Einzelzellenaufnahmen 132, die in der ersten Hauptebene 144 angeordnet sind, und zwei Einzelzellenaufnahmen 132, die in der zweiten Hauptebene 146 angeordnet sind, auf. Die Hauptebenen 140 weisen jeweils mehr Einzelzellenaufnahmen 132 auf, als die Zwischenebene 142. Zwischen den Hauptebenen 140 ist die Zwischenebene 142 angeordnet, in der eine einzige Einzelzellenaufnahme 132 angeordnet ist. Die Hauptebenen 140 und die Zwischenebenen 142 verlaufen jeweils durch die Mittelachsen 138 der ihr zugeordneten Einzelzellenaufnahmen 132.

Die Einzelzellenaufnahmen 132 sind derart angeordnet, dass ein Abstand 150 zwischen der ersten oder der zweiten Hauptebene 144, 146 und der Zwischenebene 142 in einem Bereich zwischen 54% und 60% eines Durchmessers 152 der Akkuzellen 106. Der Durchmesser 152 der Akkuzellen 106 entspricht dabei im Wesentlichen einem Durchmesser der Einzelzellenaufnahmen 132. Der Abstand 150 zwischen der ersten Hauptebene 144 und der Zwischenebene 142 und der Abstand 150 zwischen der zweiten Hauptebene 146 und der Zwischenebene 142 ist beispielhaft im Wesentlichen gleich ausgebildet.

Die Leiterplatte 114 des Akkupacks 100 ist im Wesentlichen parallel zu den Hauptebenen 140 angeordnet. Der Abstand 154 zweier benachbarter Mittelachsen 138 von Einzelzellenaufnahmen 132 innerhalb einer Hauptebene 140 ist dabei größer als eine Breite 156 der Leiterplatte 114 ausgebildet, insbesondere um mehr als 75% größer als die Breite 156 der Leiterplatte 114, ausgebildet. Der Abstand 154 der Akkuzellen 106 in den Hauptebenen 140 ist beispielhaft gleich ausgebildet. Es wäre allerdings ebenso denkbar, dass unterschiedliche Hauptebenen unterschiedliche Abstände zwischen den ihr zugeordneten Einzelzellenaufnahmen aufweisen.

Der Zellenhalter 110 spannt einen Leiterplattenaufnahmebereich 158 auf, der zur Aufnahme der Leiterplatte 114 ausgebildet ist, wobei die Leiterplatte 114 vollständig in dem Leiterplattenaufnahmebereich 158 angeordnet ist. Der Leiterplattenaufnahmebereich 158 ist oberhalb der Einzelzellenaufnahme 132 der Zwischenebene 142 und zwischen den zwei Einzelzellenaufnahmen 132 der ersten Hauptebene 144 angeordnet. Dadurch ist die Leiterplatte derart angeordnet ist, dass die Leiterplattenebene 115 einen Abstand 159 von der der ersten Hauptebene 144 aufweist, der in einem Bereich zwischen 30% und 55% des Durchmessers 152 der Akkuzellen 106 bzw. der Einzelzellenaufnahmen 132 liegt, wodurch der Akkupack 100 besonders kompakt aufgebaut ist.

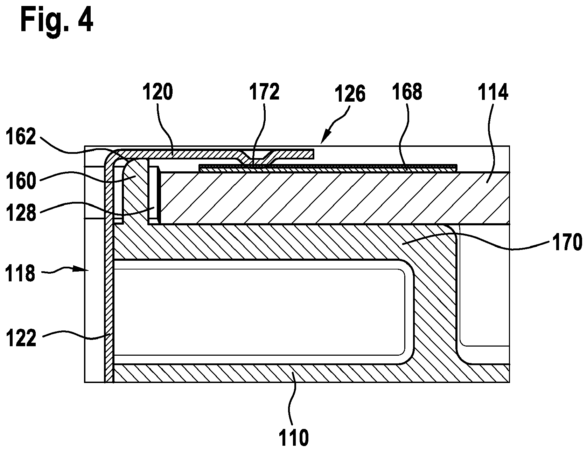

In Fig. 4 ist ein Schnitt durch eine Verbindungsstelle 126 gezeigt, über die der Zellverbinder 118 mit der Leiterplatte 114 verbunden ist.

Vor der Montage erstreckt sich der Zellverbinder 118 im Wesentlichen vollständig in einer Ebene. Das Leiterplattenverbindungselement 120 erstreckt sich somit vor der Montage als Fortsatz geradlinig ausgehend von dem Zellenverbindungselement 122 in Richtung der Leiterplatte 114.

Da die Verbindungsstelle 126 auf einer den Akkuzellen 106 abgewandten Seite angeordnet ist, wird der Zellverbinder 110, insbesondere das Leiterplattenverbindungselement 120, durch die Aussparung 128 der Leiterplatte 114 geführt, sodass das Leiterplattenverbindungselement 120 auf der Oberseite der Leiterplatte 114 herausragt.

Der Zellenhalter 110 weist eine Montagehilfe 160 auf, die in der Aussparung 128 der Leiterplatte 114 angeordnet ist. Die Montagehilfe 160 weist eine Länge auf, die größer als eine Dicke der Leiterplatte 114 ist, sodass die die Montagehilfe 160 auf der Oberseite der Leiterplatte 114 herausragt. Die Montagehilfe 160 weist eine abgerundete Kante 162 auf, die auf einer der Verbindungsstelle 126 abgewandten Seite angeordnet ist. Der Zellverbinder 118 ist ebenfalls auf der Seite der Montagehilfe 160 angeordnet, die der Verbindungsstelle 126 abgewandt ist.

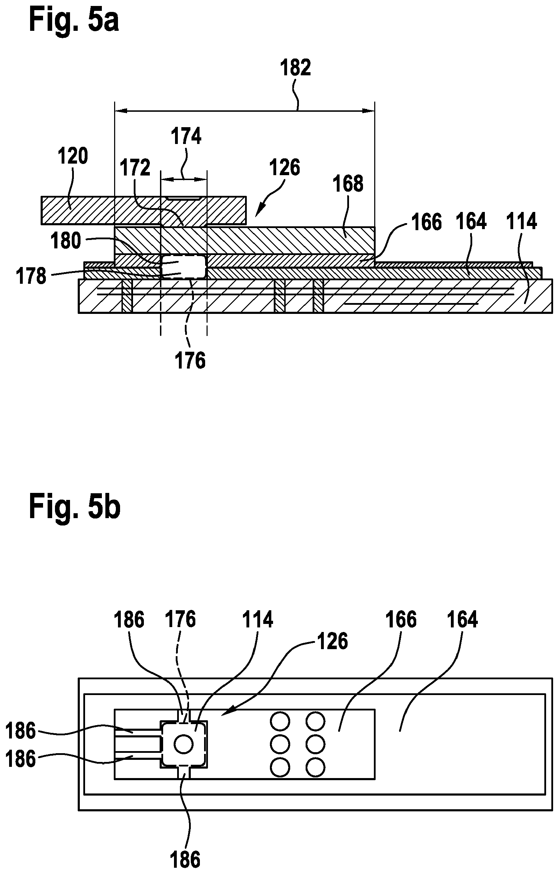

In Fig. 5a und in Fig. 5b ist die Verbindungsstelle 126 zur besseren Veranschaulichung in einer schematischen Seitenansicht und in einer schematischen Draufsicht gezeigt.

Die Verbindungsstelle 126 weist eine Kontaktfläche 164 auf. Die Kontaktfläche 164 ist beispielhaft als ein Kupferpad auf der Außenlage der Leiterplatte 114 ausgebildet. Die Kontaktfläche 164 ist mittels einer Lötverbindung über eine Lötschicht 166 mit einem Schweißplättchen 168 verbunden. Das Schweißplättchen 168 besteht aus einem metallischen Werkstoff. Beispielhaft besteht das Schweißplättchen 168 aus dem gleichen Material wie der Zellverbinder 118. Es ist allerdings ebenso denkbar, dass das Schweißplättchen 168 aus einem anderen Material besteht.

Das Schweißplättchen 168 erstreckt sich parallel zu der Leiterplattenebene 115 (siehe Fig. 3). Zur Verbindung des Zellverbinders 118 mit der Verbindungsstelle 126 der Leiterplatte 114, insbesondere zur Verbindung des Leiterplattenverbindungselements 120 mit dem Schweißplättchen 168, wird das Leiterplattenverbindungselement 120 im Bereich der abgerundeten Kante 162 der Montagehilfe 160 um diese gebogen und oberhalb der Verbindungsstelle 126 geführt. Die Montagehilfe 160 endet ungefähr auf Höhe des Schweißplättchens 168, sodass das Leiterplattenverbindungselement 120 im montierten Zustand auf der Montagehilfe 160 und auf dem Schweißplättchen 168 aufliegt.

Die Verbindung des Leiterplattenverbindungselements 120 mit dem Schweißplättchen 168 erfolgt beispielhaft über ein Widerstandsschweißverfahren. Das Leiterplattenverbindungselement 120 wird hierzu in Kontakt mit dem Schweißplättchen 168 gebracht. Das Widerstandsschweißen erfolgt über zwei Elektroden zwischen denen eine Spannung angelegt wird. In der gezeigt Ausführungsform wird eine Elektrode auf den Zellverbinder 118 oberhalb der Verbindungsstelle 126 aufgesetzt und die zweite Elektrode wird direkt auf das Schweißplättchen 168 aufgesetzt.

Alternativ wäre auch denkbar, dass der Zellverbinder 118 zwei Leiterplattenverbindungselemente 120 aufweist, die über einen Spalt getrennt und parallel zueinander verlaufen, und jeweils eine Elektrode auf ein Leiterplattenverbindungselement 120 derart aufgesetzt wird, dass der Spalt zwischen den Elektroden angeordnet ist.

Da die Verbindung auch unter einer Krafteinwirkung auf die Leiterplatte 114 im Bereich der Verbindungsstelle 126 erfolgt, weist der Akkupack 100, insbesondere der Zellenhalter 110, ein Stützelement 170 auf, auf dem die Leiterplatte 114 im Bereich der Verbindungsstelle 126 aufliegt und dadurch abgestützt wird. Somit ist das Stützelement 170 sowohl als Montageanschlag zur Ausrichtung der Leiterplatte 114 und als Gegenlager während des Schweißprozesses ausgebildet. Die Montagehilfe 160 und das Stützelement 170 sind beispielhaft einstückig mit dem Zellenhalter 110 ausgebildet.

Der Zellverbinder 118, insbesondere das Leiterplattenverbindungselement 120, weist eine Dimpel 172 auf, über den die Auflagefläche des Zellverbinders 118 auf dem Schweißplättchen 168 verkleinert wird. Der Dimpel 172 des Zellverbinders 118 erstreckt sich dabei in Richtung der Leiterplatte 114. Die zum Schweißen erforderliche Energie bzw. Wärme wird im Wesentlichen im Bereich des Dimpels 172 eingebracht. Dieser Bereich entspricht somit einem direkten Schweißbereich 174.

Die Verbindungsstelle 126 weist im direkten Schweißbereich 174 einen Hohlraum 176 auf, der dazu ausgebildet ist, den Wärmetransfer während des Schweißverfahrens lokal zu verringern. Der Hohlraum 176 ist zwischen dem Schweißplättchen 168 und der Leiterplatte 114 ausgebildet.

Der Hohlraum 176 ist in der gezeigten Ausführungsform durch eine Aussparung 178 in der Kontaktfläche 164 und eine Aussparung 180 in der Lötschicht 166 gebildet. Die Aussparungen 178, 180 weisen beispielhaft im Wesentlichen den gleichen Querschnitt auf, es ist aber auch denkbar, dass die Aussparungen 178, 180 unterschiedliche Querschnitte und damit Größen aufweisen. Die Aussparungen 178, 180 haben beispielsweise einen rechteckigen Querschnitt, es sind allerdings auch andere Formen, wie beispielsweise quadratisch, rund, dreieckig, mehreckig, etc. denkbar

Durch den Hohlraum 176 wird somit eine Überhitzung im direkten Schweißbereich 174 verhindert und die Wärme besser über den gesamten Schweißbereich 182 verteilt.

Zudem weist die Leiterplatte 114 Entgasungskanäle 186 zur Expansion eingeschlossener Luft auf, die beispielhaft als Aussparungen in der Lötschicht 166 und in der Kontaktfläche 164 ausgebildet sind.

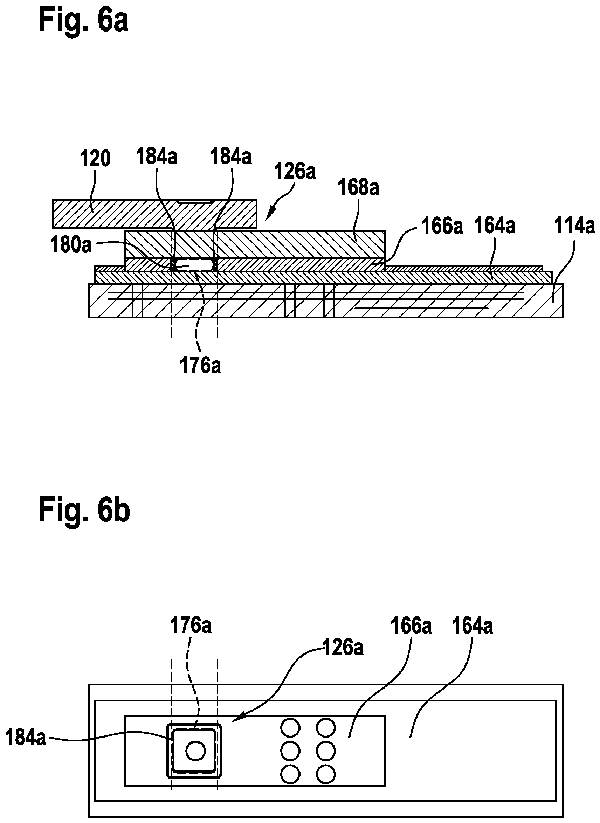

In Fig. 6a und Fig. 6b ist eine alternative Ausführungsform der Verbindungsstelle 126 gemäß Fig. 4 gezeigt. Die Verbindungsstelle 126a unterscheidet sich dabei insbesondere dadurch, dass der Hohlraum 176a nur in der Lötschicht 166a in Form einer Aussparung 180a angeordnet ist. Somit ist der Hohlraum 176a zwischen dem Schweißplättchen 168a und der Kontaktfläche 164a angeordnet. Herstellbar ist dieser Hohlraum 176a beispielsweise durch den Einsatz von Lötstoppstegen 184a, die die Aussparung 180a begrenzen bzw. bilden.

## Patentansprüche

1. Akkupack mit einem Gehäuse (104), mit zumindest einer Akkuzelle (106), mit einem Zellverbinder (118) und mit einer Leiterplatte (114), wobei die zumindest eine Akkuzelle (106) über den Zellverbinder (118) mit der Leiterplatte (114) elektrisch verbunden ist,
**dadurch gekennzeichnet, dass**
die Leiterplatte (114) eine Verbindungsstelle (126) zur stoffschlüssigen Verbindung des Zellverbinders (118) mit der Leiterplatte (114) aufweist, wobei die Verbindungsstelle (126) auf einer den Akkuzellen (106) abgewandten Seite der Leiterplatte (114) angeordnet ist.

2. Akkupack nach Anspruch 1, **dadurch gekennzeichnet, dass** der Akkupack (100) eine Montagehilfe (160) zur Unterstützung der Montage aufweist.

3. Akkupack nach Anspruch 2, **dadurch gekennzeichnet, dass** die Leiterplatte (114) eine Aussparung (128) aufweist, in der die Montagehilfe (160) und der Zellverbinder (118) angeordnet sind, wobei die Montagehilfe (160) eine Länge aufweist, die größer als eine Dicke der Leiterplatte (114) ausgebildet ist.

4. Akkupack nach einem der Ansprüche 2 bis 3, **dadurch gekennzeichnet, dass** die Montagehilfe (160) auf der der Verbindungsstelle (126) abgewandten Seite eine abgerundete Kante (162) aufweist, die zum Biegen des Zellverbinders (118) vorgesehen ist.

5. Akkupack nach einem der vorhergehenden Ansprüche, **dadurch gekennzeichnet, dass** der Akkupack (100) ein Stützelement (170) aufweist, auf welchem die Leiterplatte (114) im Bereich der Verbindungsstelle (126) aufliegt.

6. Akkupack nach einem der vorhergehenden Ansprüche, **dadurch gekennzeichnet, dass** die Leiterplatte (126) eine Kontaktfläche (164) aufweist, die stoffschlüssig über ein Stoffschlussmittel, insbesondere über eine Lötschicht (166), mit einem Schweißplättchen (168) verbunden ist.

7. Akkupack nach Anspruch 6, **dadurch gekennzeichnet, dass** der Zellverbinder (118), insbesondere ein Dimpel (172) des Zellverbinders (118), direkt mit dem Schweißplättchen (168) verbunden ist.

8. Akkupack nach einem der Ansprüche 6 bis 7, **dadurch gekennzeichnet, dass** das Stoffschlussmittel (166) und/oder die Kontaktfläche (164) und/oder das Schweißmetallplättchen (168) eine Aussparung (178, 180) aufweist.

9. Akkupack nach einem der Ansprüche 6 bis 8, **dadurch gekennzeichnet, dass** das Schweißmetallplättchen (168) einen Dimpel aufweist, der sich in eine der Leiterplatte (114) abgewandten Richtung erstreckt.

10. Akkupack nach einem der Ansprüche 8 bis 9, **dadurch gekennzeichnet, dass** die Aussparung (178, 180) in einem Schweißbereich (174), insbesondere im Bereich des Dimpels (172), angeordnet ist.

11. Akkupack nach einem der Ansprüche 6 bis 10, **dadurch gekennzeichnet, dass** das Stoffschlussmittel (166) und/oder die Kontaktfläche (164) zumindest einen Entgasungskanal (186) zur Expansion eingeschlossener Luft aufweist.

12. Verfahren zum Verschweißen eines Zellverbinders (118) auf einer Leiterplatte (114), wobei der Zellverbinder (118) über ein Schweißplättchen (168) auf eine Kontaktfläche (164) der Leiterplatte (114) aufgeschweißt wird,
**dadurch gekennzeichnet, dass**
in einem direkten Schweißbereich (174) ein Hohlraum (176) zwischen dem Schweißplättchen (168) und der Leiterplatte (114) angeordnet ist.

13. Verfahren nach Anspruch 12, **dadurch gekennzeichnet, dass** das Schweißplättchen (168) über ein Stoffschlussmittel, insbesondere über eine Lötschicht (166), mit der Leiterplatte (114) verbunden ist und das Stoffschlussmittel (166) und/oder die Kontaktfläche (164) und/oder das Schweißmetallplättchen (168) eine Aussparung (178, 180) aufweist.

14. Verfahren nach einem der Ansprüche 12 oder 13, **dadurch gekennzeichnet, dass** das Schweißen über ein Widerstandsschweißverfahren oder ein Laserschweißverfahren erfolgt.

15. Verfahren nach einem der Ansprüche 12 bis 14, **dadurch gekennzeichnet, dass** die Kontaktfläche (164) als eine Metallisierung in einer Außenlage der Leiterplatte (114) ausgebildet ist.
